Europäisches Patentamt

European Patent Office

Office européen des brevets

(11) Publication number: **0 034 816**
**B1**

(12) **EUROPEAN PATENT SPECIFICATION**

(45) Date of publication of patent specification: **02.01.85**

(21) Application number: **81101205.3**

(22) Date of filing: **20.02.81**

(51) Int. Cl.⁴: **G 03 C 5/24,** G 03 G 13/00,
G 03 G 17/00, G 03 G 15/16

(54) Multiple transfer of tacky image areas using prolonged tack toners.

(30) Priority: **25.02.80 US 124605**

(43) Date of publication of application:
**02.09.81 Bulletin 81/35**

(45) Publication of the grant of the patent:
**02.01.85 Bulletin 85/01**

(84) Designated Contracting States:
**BE DE FR GB IT LU NL**

(56) References cited:
**DE-A-2 758 209**
**US-A-3 013 878**
**US-A-3 060 024**
**US-A-3 620 726**
**US-A-3 649 268**
**US-A-3 965 478**
**US-A-4 075 637**
**US-A-4 174 216**

(73) Proprietor: **E.I. DU PONT DE NEMOURS AND
COMPANY**
**1007 Market Street**
**Wilmington Delaware 19898 (US)**

(72) Inventor: **Held, Robert Paul**
**82 Knox Lane**
**Englishtown New Jersey 07726 (US)**

(74) Representative: **Werner, Hans-Karsten, Dr. et al**
**Deichmannhaus am Hauptbahnhof**
**D-5000 Köln 1 (DE)**

Courier Press, Leamington Spa, England.

**0 034 816**

## Description

Technical field

This invention relates to a process for the development of latent images. More particularly the invention relates to a dry process for transfer of a toned tacky image to an image receptor. Still more particularly the invention relates to a process for producing multiple transfers using a toner having prolonged tack characteristics, and apparatus therefor.

Background art

Processes are known whereby surfaces bearing latent images are developed through the application of toner particles. For example, in the case where the latent image comprises tacky and nontacky areas, a conventional toner may be used to develop such image. Once the latent image is covered completely with toner, it is not possible to apply more toner to increase the density of the toned image. In some of these processes, the toned latent images can be subsequently transferred to separate image receptors forming images thereon. While multiple copies of the toned images can be made, the number of copies is generally few in number, e.g., up to about 5 copies, since the image areas as well as the adhering toner transfer to the image receptors.

Prolonged tack materials prepared from thermoplastic resins and a plasticizer are known which on heating become tacky or sticky and retain this tackiness for a considerable time even after cooling. This property, also known as delayed tack or setting, has been found useful in the preparation of adhesive compositions, as well as in thermography to produce a master which is imagewise exposed by means of heat, toned, and the toned image is then transferred onto an image receptor to provide a copy of the original image. In this described process the prolonged tack property is present in the form of a continuous film over a master sheet. Conventional toners are used to develop the tacky image areas. A subsequent transfer of the toned image onto an image receptor, e.g., paper, results in complete transfer of the toned image.

Apparatus for toner development of thermographic masters are known. One such apparatus has a belt transport which carries a master sequentially past toning, heating, transferring and brush cleaning stations. Also known are laterally vibrating pads to redistribute toner particles and a laterally vibrating toner hopper. Furthermore, a combination air knife/vacuum cleaner for toner removal which can be used in combination with a brush means to improve its efficiency is known. No apparatus is believed to be known which incorporates toning, cleaning, heating and transferring stations wherein a cooling means is provided following the transferring station to cool the master surface prior to retoning of the tacky image.

Brief description of drawings

In the accompanying drawings forming a material part of this disclosure.

Figure 1 is a flow sheet showing an image transfer embodiment of the invention.

Figure 2 is an elevation with parts in section showing the various parts of an apparatus for practicing this invention wherein a latent image having tacky and nontacky images is employed.

Disclosure of invention

In accordance with this invention there is provided a process for image development of a substrate having latent image areas which comprises

(a) applying to the latent image areas a prolonged tack toner to produce a nontacky toned image,

(b) heating the toned image to a temperature sufficient to activate the toner by rendering the toner tacky, characterized by the further steps of

(c) reducing the temperature of the tackified toned image below the activating temperature of the prolonged tack toner wherein the activated prolonged tack toner remains tacky,

(d) further applying prolonged tack toner to the tackified toned image, and

(e) repeating steps (b) through (d) at least one time to increase the density of the toned image on the substrate.

In accordance with another embodiment of this invention there is provided a process for forming toned images from a substrate master having latent image areas which comprises

(a) applying to the latent image areas of the substrate a prolonged tack toner to produce a nontacky toned image,

(b) heating the toned image to a temperature sufficient to activate the toner by rendering the toner tacky,

(c) bringing the tacky toned substrate into intimate contact with an image receptor, and, while the toner is still activated,

(d) separating the substrate and image receptor whereby a portion of the activated prolonged tack toner transfers imagewise to the image receptor, characterized in that following step (b) the step

2

(b') reducing the temperature of the tackified toned substrate below the activating temperature of the prolonged tack toner wherein the toner remains tacky is performed and steps (a) and (b) are repeated at least one time.

Furtheron the present invention discloses a process for forming toned images from a substrate master having latent image areas which comprises

(a) applying to the latent image areas of the substrate a prolonged tack toner to produce a nontacky toned image,

(b) heating the toned image to a temperature sufficient to activate the toner by rendering the toner tacky,

(c) bringing the tacky toned substrate into intimate contact with an image receptor, and, while the toner is still activated,

(d) separating the substrate and image receptor whereby a portion of the activated prolonged tack toner transfers imagewise to the image receptor,

characterized in that following step (d), step (e) reducing the temperature of the prolonged tack toner transferred to the image receptor below the activating temperature of the prolonged tack toner and applying additional prolonged tack toner over the still tacky image to increase the density of the toned transferred image is performed.

In accordance with still another embodiment of this invention there is provided an apparatus for the production of multiple copies from a substrate master having tacky image areas and nontacky background areas onto an image receptor which comprises support means for the substrate capable of sequentially and cyclically transporting the substrate, in order, past the following stations located adjacent to the support means:

(1) a toner applicator to apply a uniform layer of prolonged tack toner particles onto the tacky image areas of the substrate (11);

(2) a toner cleaner extending the full width of the support means comprising an air knife (17) and at least one vacuum nozzle (16) located in close proximity to the air knife for removing toner particles dislodged from the nontacky background areas of the substrate by the action of the air knife; optionally

(3) a cleaning belt (18) held in contact with the support means and extending the full width of the support means capable of vibrating in a direction transverse to the direction in which the toned substrate is transported,

(4) heating means (23) for heating the toned substrate to raise the temperature of the prolonged tack toners above the temperature at which the toners become tackified;

(5) an image transfer means comprising rollers (26, 27) for bringing the tacky toned substrate into intimate contact with the image receptor (25), characterized by

(6) a cooling air supply (31) extending the full width of the support means for providing cooling air over the toned substrate to reduce the temperature of the prolonged tack toners below the temperature at which the toners become tackified, the cooling air supply being located ahead of station (1).

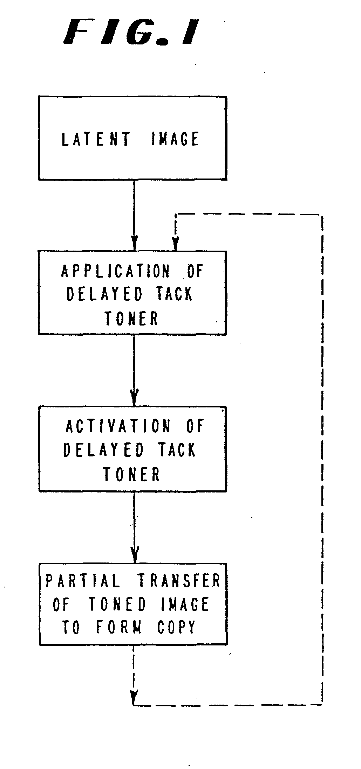

Referring to the drawings, and more particularly to Figure 1, this figure shows, in the form of a flow sheet, the basic steps of a preferred embodiment of the invention wherein multicopies of a toned image, i.e., toned with prolonged tack toners, are transferred to separate image receptors. The latent image is present in a substrate. As used in this specification, latent image means any image capable of being developed through the application of toner particles, including, but not limited to, electrostatic, electromagnetic, or images comprising tacky areas and nontacky background areas.

This invention will be further illustrated using the particular case of a latent tacky image. Suitable substrates are supported layers which are capable of forming tacky images on their surface, either directly, e.g., by exposure to actinic radiation, or by treatment with solutions, heat, or other means. Preferably the tacky images are formed in photosensitive layers which may be comprised of positive-working or negative-working compositions. Suitable positive-working compositions are photohardenable, e.g., photopolymerizable compositions disclosed, for example, in Chu and Cohen U.S. Patent 3,649,268, and suitable negative-working compositions are disclosed, for example, in Abele and Grossa German Application P 27 58 209.8, filed December 27, 1977, and Cohen and Fan U.S. Patent 4,174,216.

The terms "photopolymerizable" and "photohardenable" as used herein refer to systems in which the molecular weight of at least one component of the photosensitive layer is increased by exposure to actinic radiation sufficiently to result in a change in the rheological and thermal behavior of the exposed areas.

The term "prolonged tack toner" as used herein refers to toners which are nontacky at room temperature but which upon heating to an elevated temperature become and remain tacky for a period of time even though the temperature of the toner returns or is returned to a temperature, below the temperature at which the toner became tacky, including room temperature. Such toners are sometimes referred to as delayed tack toners. Suitable prolonged tack toners having the aforementioned properties can be prepared by combining a thermoplastic resin, e.g., polystyrene, with a plasticizer or heat activatable tackifying agent such as N-cyclohexyl-p-toluenesulfonamide or a copolymer of methylmethacrylate(90)/methacrylic acid(10) and triphenyl phosphate plasticizer, in a proportion such that the plasticizer, component is present in an amount greater than its compatibility level in the resin. A dye or colored pigment, e.g., carbon black, is combined with a resin/plasticizer component, colorant and particles having a size distribution within the range of 0.2 to 30 micrometers and not more than 50% of the colorant particles being less than 1 micrometer particle size as described in U.S. Patent 3,620,726, etc. Other suitable additives to the toner are disclosed in U.S. Patent 3,649,268 referred to above, and in U.S. Patent 3,060,025.

Among suitable photopolymerizable or photohardenable compositions are: (1) those in which a photopolymerizable monomer is present alone or in combination with a compatible binder, or (2) those in which the photopolymerizable groups are attached to a polymer backbone which becomes activated to light and may then crosslink by reacting with a similar group or other reactive sites on adjacent polymer chains. In the second group of suitable photopolymerizable systems, where the monomer or pendant photopolymerizable group is capable of addition polymerization, e.g., a vinyl monomer, the photopolymerized chain length may involve addition of many similar units initiated by a single photochemical event. Where only dimerization of similar compounds is involved, e.g., benzophenone or cinnamoyl compounds, the average molecular weight of the photosensitive constituent can be at best only doubled by a single photochemical act. Where a photopolymerizable molecule has more than one reactive site, a crosslinked network can be produced.

If either a simple monomer or monomer–polymer binder composition is being used, the photosensitive layer preferably contains a free radical generating, addition polymerization initiator. Plasticizing agents, as well as other known additives, can be present in the photosensitive layer.

Suitable free radical initiated, chain propagating, addition polymerizable, ethylenically unsaturated compounds for use in the monomer or monomer–polymer binder photopolymerizable layers are described in U.S. Patents 3,060,023, 3,261,686 and 3,380,831. Polymers for use in the monomer–polymer binder system and preferred free radical generating addition polymerization initators are described in U.S. Patent 3,060,023.

Photodimerizable materials useful in the invention are cinnamic acid esters of high-molecular weight polyols, polymers having chalcone and benzophenone type groups, and others disclosed in Chapter 4 of "Light-Sensitive Systems" by Jaromir Kosar published by John Wiley & Sons, Inc., New York, 1965. Photopolymerizable materials capable of photocrosslinking with more than one adjacent polymeric chain to form a network are described in U.S. Patents 3,418,295 and 3,469,982.

Preferred free radical generating addition polymerization initiators, activatable by actinic radiation, e.g., ultraviolet and visible radiation, are listed in U.S. Patent 3,060,023 and the other patents referred to above.

Suitable plasticizers include: dialkyl phthalate, polyoxyethylene(4)monolaurylether, polyethylene glycol, triethylene glycol diacetate, alkyl phosphates, etc.

The photosensitive layer, 0.0003 to 0.004 inch (0.0076 to 0.10 mm) thick, can be present on a surface such as a polymer film, plastic, metal or sheet such as paper, whereon it adheres. The photosensitive composition can be either laminated or coated on the surface under conditions known to those skilled in the art. A known protective film such as is described in U.S. Patent 3,060,026, can be present on the photosensitive layer. The protective film, e.g., polyethylene terephthalate, polyethylene, etc., can be present during imagewise exposure but is removed prior to application of the prolonged tack toner to the tacky image surface.

The photopolymerizable layer is exposed to actinic radiation, generally through a process transparency, e.g., a process negative or positive (an image-bearing transparency consisting solely of substantially opaque and substantially transparent areas where the opaque areas are substantially of the same optical density).

Since photosensitive compositions of this invention generally exhibit their maximum sensitivity in the ultraviolet range, the radiation source should furnish an effective amount of this radiation. Such sources include carbon arcs, mercury-vapor arcs, fluorescent lamps with special ultraviolet-emitting phosphors, argon glow lamps, electronic flash units and photographic flood lamps. The amount of exposure required for satisfactory reproduction of a given photosensitive layer is a function of intensity, type of radiation source used, and distance between the radiation source and layer surface. In general, exposure times range from 10 seconds to 10 minutes or more using standard commercial radiation sources.

Subsequent to the formation of the latent image, and removal of any cover sheet, if present, the tacky image areas are toned with particles of a prolonged tack toner, of the type described above. The toner particles adhere primarily in the tacky image areas. Any toner particles which should remain in the nontacky background areas can be removed by means known in the art, e.g., wiping, air devices, etc. The prolonged tack toner particles are then activated by heating the toner particles to at least a temperature wherein the toner particles become tacky. The activated tacky toned image-bearing substrate is brought into intimate contact, e.g., under pressure, with an image receptor, e.g., paper, film, copper clad fiberglass epoxy or phenolic resin board, etc. Upon separation of the two surfaces, the toner fails cohesively and a portion thereof transfers imagewise to the image receptor. After reducing or permitting the temperature of the prolonged tack toner particles to be reduced below their activating temperature, wherein the prolonged tack toner particles remain tacky for a period of time, the process can be repeated, as shown by the dotted lines in Figure 1 using a new image receptor to receive each additional transferred image.

In order to practically illustrate the above-described process, a photopolymerizable element, such as is described in Example I of U.S. Patent 3,736,138, is used, e.g., having a 0.0004 inch (0.010 mm) photopolymerizable layer coated on a 0.007 inch (0.18 mm) resin subbed polyethylene terephthalate support, with the other side of the photopolymerizable layer covered with a 0.001 inch (0.025 mm) polyethylene terephthalate film as a cover sheet. The element is placed in a vacuum frame, a halftone positive is placed over the photopolymerizable layer, and following the application of vacuum for one minute, the element is exposed to actinic radiation for about 20 seconds using a nuArc "Flip Top" Plate Maker, Model FT-26-L pulsed xenon light source. After exposure, the exposed element is removed from the vacuum frame and the cover sheet is removed.

The photopolymerizable layer exhibits a higher degree of tackines in the areas which received less actinic radiation, thus presenting a latent image which is rendered visible through the application of toner particles. When toner particles are uniformly distributed over the imaged layer, the particles adhere to the tacky portions of the imaged layer. A device such as disclosed in U.S. Patent 4,019,821 is useful for the uniform application of toner particles onto such an imagewise tacky surface, since by its use the toner particles remain solely in the tacky image areas with the nontacky background areas being toner free.

The aforementioned use of a photopolymerizable element such as taught in U.S. Patent 3,736,138 and a toning device such as disclosed in U.S. Patent 4,019,821 is merely illustrative. For the practice of this invention, as noted above, all that is necessary is an image capable of accepting a prolonged tack toner of the type disclosed below and some method for applying the toner thereon.

In particular, when an automatic apparatus is used in conjunction with this process, the toner application may be accomplished in any of a number of ways known in the art. A typical toner applicator is shown in Figure 1 of U.S. Patent 3,260,612; an applicator of the type disclosed in U.S. Patent 3,013,878 may be employed. A simple applicator as shown in U.S. Patent 3,965,478 may also be used, while the use of a more sophisticated version such as shown in U.S. Patent 3,670,701 is also useful.

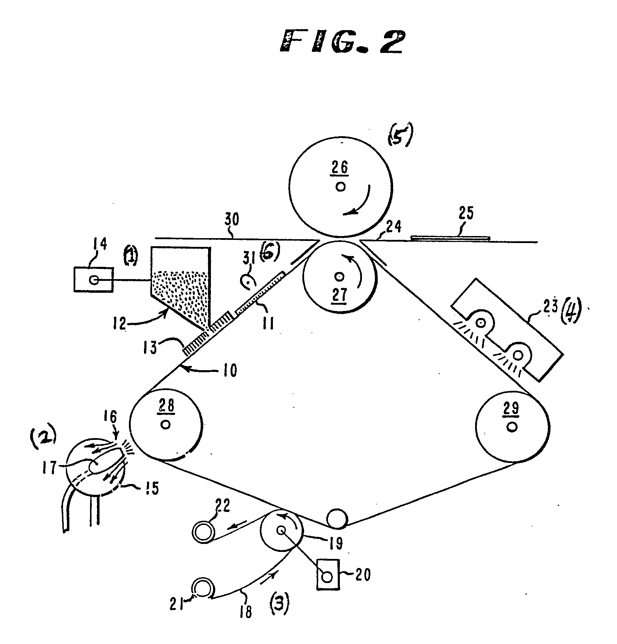

Figure 2 shows the various parts of one embodiment of an apparatus of the invention for the automatic implementation of the image transfer embodiment. While a belt support means for the photosensitive substrate is shown to receive, support and transport the substrate containing the latent image past the various treatment stations, a drum can be readily substituted for the belt.

An imaged substrate master 11, hereinafter referred to as "master", of the type described above is first affixed onto carrier belt 10 at a point ahead of toner hopper 12. As the master enters the toner application station, designated station 1, the hopper is activated and toner is delivered onto the master surface. A vibrating driving means 14 is used to impart a vibratory motion to a wall of the hopper and to brush 13 attached to the lower end of the hopper wall. This vibratory motion which is generally in a direction transverse to the direction of motion of master 11 is useful in maintaining agitation of the toner in the hopper and assuring an even flow distribution. Additionally, brush 13 which is located close enough to the carrier belt 10 so that master 11 is driven in contact with the brush bristles, serves to simultaneously redistribute the toner particles over the imaged surface, improving the adhesion of toner particles onto the tacky portions of master 11 while removing toner particles from the nontacky areas.

Following the application of toner particles, master 11 is brought under the action of toner cleaner 15, designated station 2. As illustrated, two vacuum suction ports 16 surround air knife 17. Air knife 17 blows air forcibly over the toned master surface, removing loose toner particles from the surface, which are suctioned away through ports 16.

Optionally a cleaning belt station, designated station 3, is located in the apparatus after the toner cleaner 15. It consists essentially of a Las-tik® cloth wiper which is brought into contact with the toned master surface under light pressure provided by roller 19. Roller 19 is adapted to rapidly oscillate in a direction transverse to the master advance and to slowly rotate around its axis, constantly supplying a clean cloth to the master surface from a cloth supply spool 21. A take-up spool 22 is provided to take up the spent cloth which is stained with remaining loose toner particles removed from the master surface.

Following the toning and thorough cleaning operations, the surface of the master is exposed to sufficient heat to activate and tackify the toner particles by passing it under a heating means 23, designated station 4, which may comprise infrared or other type heaters.

Upon exposure to the heat, the toner particles, which up to this point are hard, become fluid and tacky. As described above, the toner composition is such that the toner particles remain tacky following activation, e.g., for a period of time which may vary from a few minutes or seconds to hours or days.

This tackiness is maintained even though the toner temperature drops below the tackifying temperature.

Following toner activation, the master enters station 5 where its surface is brought into contact, under pressure, with an image receptor 25, e.g., paper, etc. between pressure roller 26 and support roller 27. A means 24 and 30 are provided to guide the image receptor in and out of contact with the master surface. Upon contact with the surface of the image receptor 25, the tackified toner partially transfers onto the surface of the receptor. It is important that the adhesive force between the tackified toner and both the master and receptor surfaces be greater than the cohesive force between the tackified toner particles. Thus, when the image receptor is removed from contact with the master, the toner breaks cohesively and a portion of the toner remains on the master while another portion remains adhered to the image receptor to provide a visible image of the original.

The master surface remains on the carrier belt and is again driven past the toner application station 1. Just ahead of the toner application station is situated a cooling air supply 31, designated station 6, thus assuring that the master surface temperature is reduced to below the tackifying temperature of the toner. This is necessary, since it is desired that the new toner particles remain nontacky so as to prevent smearing after they contact the master surface, adhering only to the previously tackified toner still remaining on the master. The cooling air supply 31 comprises a nozzle attached to a cold air source (not shown).

The process can be repeated as many times as desired, each time providing a high quality copy on a new image receptor and regenerating a tacky image for additional toner application.

Best mode for carrying out the invention

The best mode is illustrated in Example 12 wherein the toned image of Example 1 is transferred to an aluminum plate to produce a printing plate as described in Example 7. The transferred image is treated with an aqueous solution of triethanolamine titanate chelate, and the treated plate is heated to at least 150°C. After attaching the plate to a duplicating machine, many thousands of inked impressions are made.

Industrial applicability

The invention is useful for the preparation of toned images of high optical density wherein a tackified toned image on a substrate master is retoned with additional toner a number of times, so as to build the image density on the master surface to any desired point. This is particularly useful in applications where the tacky image has been created on a transparent support such as a polyethylene terephthalate film of the type disclosed in U.S. Patent 2,779,684. When a toned image is developed on a transparent base material, it tends to be translucent due to the fact that it is difficult to apply a thick enough layer of toner particles, to prevent light from shining through the transparent base. A thick enough layer cannot be applied in one toning operation because once the tacky image is covered with toner it ceases to accept any more as its tackiness is masked by the first toner layer. However, by the use of this process where each toner layer itself becomes toner receptive, a sufficient number of layers may be sequentially added onto each other to provide the needed opacity or higher density without significant resolution loss.

The substrate master, instead of being tacky, as described above, can contain latent images that are magnetic or electrostatic. These latent images are toned with prolonged tack toners having magnetic or electrostatic properties, respectively, and subsequently the toners can be transferred to a support and used as described above. Alternatively the toners can be heated to activate the toner's tack, retoned with the same or a different toner to increase toner coverage, and, optionally, transferred to a receptor.

The prolonged tack toned image of the types described above can be used in single or multiple transfers to an image receptor using the same or different toners. The transferred image can also be toned subsequently with additional prolonged tack toner to generate a higher density transferred image. Multicolored images can be prepared on a single image receptor by preparing a desired number of photosensitive elements, e.g., up to four, exposing each element through a different color separation transparency and toning each tacky element with the appropriately colored prolonged tack toner. Each toned image is then transferred in register to the same image receptor.

Resist images can be formed by transferring the toned image to copper clad laminates, e.g., phenolic resin or fiberglass epoxy boards, for example, and subsequently etching or plating the boards in the conventional manner.

Lithographic printing plates can also be prepared by transferring the toned image to a lithographic surface, e.g., an aluminum plate. The transferred image is then treated and inked to produce inked impressions of the image. It is preferred that after transfer of the image, the image is heated up to about 150°C and more preferably following treatment with triethanolamine titanate chelate or other crosslinking agents. Still better results are achieved when, after transfer while the image is still tacky and prior to heating, the toned image is retoned with a different toner containing polymer particles, e.g., polystyrene beads, pigmented polymers with maximum average diameter of about 50 microns, etc.

Examples
The following examples illustrate the invention. Parts and percentages are by weight.

Example 1
Preparation of photohardenable element
On a 0.007 inch (0.18 mm) polyethylene terephthalate film based coated with a resin sublayer, there is coated a photohardenable layer having a thickness of 0.0004 inch (0.01 mm). The photohardenable layer is of the following composition:

| Component | Parts |
| --- | --- |
| Polymethylmethacrylate, high molecular weight | 19.30 |
| Polyvinyl acetate, high molecular weight | 19.30 |
| Trimethylol propane trimethacrylate | 40.60 |
| Polyoxyethylated trimethylol propane triacrylate | 9.10 |
| Polyethylene glycol[4] lauryl ether | 9.10 |
| 2-o-chlorophenyl bisphenylimidazolyl dimer | 1.60 |
| 2,2'-dihydroxy-4-methoxy benzophenone | 0.08 |
| 2-(stilbyl-4")-(naphtho-1',2'4,5)-1,2,3-triazole-2"-sulfonic acid phenyl ester | 0.20 |
| 2-mercaptobenzothiazole | 0.80 |

Over this coated layer, there is laminated a cover sheet of 0.00075 inch (0.02 mm) polypropylene to form a photohardenable element.

Exposure of photohardenable element
The photohardenable element was placed in a vacuum frame, with the cover sheet facing the glass cover of the vacuum frame. A transparency bearing a positive halftone image of the subject to be reproduced was then placed over the cover sheet, and the vacuum frame glass cover closed. Vacuum of about 25 inches of water ($\sim$635 kg/m$^2$) was applied assuring intimate contact between the transparency and the element. Using a 2KW "Flip Top" pulsed xenon exposure unit, the sample was exposed to the pulsed source actinic output for a period of about 25 seconds. As a result of the exposure to actinic radiation, the photohardenable surface exhibits imagewise tacky (unexposed) and nontacky (exposed) areas.
The element was then removed from the vacuum frame, and the cover sheet peeled off. The exposed element was mounted on an apparatus such as is depicted in Figure 2 and was driven past a toner applicator station where toner particles were applied over the exposed photohardenable surface. Toner particles adhere to the tacky portions and the remaining toner was wiped off the element as it progressed through the cleaning stations of the apparatus, the toner cleaner and cleaning belt.

Preparation of toner and toning of exposed photohardenable element
The toned element was then subjected to heating whereby the toner particles were heated to a temperature above 50°C. At that temperature the toner particles become tacky. The particular toner used is a prolonged tack toner, and maintains its tackiness following heat activation even if the temperature is subsequently reduced to below 50°C. The prolonged tack toner comprises:

| Component | Parts |
| --- | --- |
| Triphenyl phosphate (plasticizer) | 50.4 |
| Polymethylmethacrylate(90%)/methacrylic acid (10%) (binder) | 41.2 |
| Carbon black | 8.4 |

and is prepared as follows:
A solution is first made of the plasticizer and binder components in a solvent mixture of 50% acetone and 50% methanol in which the carbon black has been dispersed. The solution is added under rapid agitation into water at a pH of 4 and relative water to solution volumes of 10/1. Following mixing, the precipitated material is filtered and dried at a temperature below that of the melting point of the toner. It is then ground up in the presence of dry ice to a particle size appropriate for use.

Image transfer

The element temperature was reduced to below 50°C by means of a cooled air flow and the element was driven past the toner applicator station for a second time. More toner was applied which adhered to the now tacky toner on the surface of the element. The process was repeated 2 or 3 times to increase the thickness of toner layer on the element, at which time transfers to an image receptor were initiated.

Transfers were accomplished by feeding a sheet of Kromekote® paper into the nip between rollers 26 and 27 of Figure 2 in contact with the activated toned surface of the element. Toner particles adhered to the paper by failing cohesively and transferring a portion of the toned image from the element onto the paper surface reproducing the image on the element. Additionally, toner remained on the surface. This surface was again cooled and transported past the toner applicator station for the addition of more toner. The image transfer was repeated 20 times.

Example 2

Four color separation halftone transparencies, i.e., magenta, yellow, cyan and black, were prepared in order to illustrate multicolor image reproduction capability. Using the four transparencies, four color separation tonable elements were prepared using a photopolymerizable element of the type described in Example 1. Each tonable element was then hand toned using a pad which was first dipped into a pan containing a prolonged tack toner of the appropriate color indicated above. The particular prolonged tack toners used were prepared by mixing the toner indicated with 15 g of Santicizer 1H, N-cyclohexyl-p-toluenesulfonamide except that the black toner contained 25 g of the sulfonamide compound:

| | |
|---|---|
| Yellow toner | 7.5 g of Xerox® yellow toner No. 6R194 |
| Cyan toner | 7.5 g Xerox® Cyan toner No. 6R192 |
| Magenta toner | 7.5 g Xerox® Magenta toner 6R198 |
| Black toner | 7.5 g Xerox® toner 6R208 |

Each toner was prepared by placing the two components in a microgrinder and grinding the mixture to a fine uniform looking powder. After toning, the magenta-toned color separation element was heated (by wrapping around a container filled with hot water) to a temperature sufficient to melt the toner (at least 83°C). After melting of the toner the magenta-toned color separation element was placed over a paper image receptor, and both the element and image receptor were transported through a heated laminator. The process was repeated using the yellow, cyan and black color separation elements in that order to provide a multicolored image on the image receptor.

The color separation tonable elements, after separation from the image receptor were cooled (the magenta-toned color separation element only was left to detackify over a weekend), retoned and reheated to melt the toner. The process was repeated using the same set of color separation elements to provide five multiple multicolored copies of the original.

Example 3

A photopolymerizable element as disclosed in Example 1 was exposed imagewise and placed on an apparatus of the type shown in Figure 2. The exposed surface was toned using the toner of Example 1, excess toner was removed, and the adhered toner heated. The toned element was brought into contact with a sheet of plain white paper in the nip between rollers 26 and 27, transferring part of the melted toner onto the paper sheet in imagewise fashion. The toned photopolymerizable element was then cooled and retoned, and the process was repeated at least five more times, producing 5 additional quality copies.

Example 4

Using the photopolymerizable element and equipment described in Example 1, an imagewise tacky surface was generated and the tacky surface was developed by toning with a prolonged tack toner prepared from 12 g of triphenyl phosphate, 8 g of polymethylmethacrylate/methacrylic acid as described in Example 2, and 16 g of Tipure® R900ED, a form of $TiO_2$ pigment available from E. I. du Pont de Nemours and Company. The image on the photohardenable layer appeared weak and lacked sufficient density. Rather than proceeding to transfer this image onto an image receptor, the toning process was repeated following heating and cooling until an image of satisfactory density was produced on the photohardenable layer.

Example 5

Example 3 was repeated through the image development step using a prolonged tack toner of the following composition:

8

| Component | Amount (g) |
|---|---|
| Polymethylmethacrylate/methacrylic acid described in Example 1 | 280.8 |
| Triethylene glycol dibenzoate | 547.9 |
| Carbon black dispersion, 48% solids | 154.0 |

Following the heating step, the image was transferred to a lithographic aluminum sheet support to provide a good image. The toned element was cooled to a temperature below the melting point of the toner, the toned element was retoned and reheated and a second transfer to another aluminum sheet support was accomplished successfully. The process was repeated six more times giving comparable results.

Example 6

Example 3 was repeated through the image development step using a prolonged tack toner (A) comprising high molecular weight polystyrene beads (6 g) and N-cyclohexyl-p-toluenesulfonamide described in Example 2 (25 g). The toned element was heated to a temperature above the melting point of the toner, followed by cooling below the toned melting point and retoning with the same toner. The retoned element was again cooled but this time to a temperature below the melting point of a second toner (B) being a physical mixture of Xerox® toner 6R208 (7.5 g) and the sulfonamide compound described above (25 g). The cooled, retoned element was now toned with toner (B) and heated to a temperature of between 110 to 120°C and then brought into contact under pressure with a copper clad phenolic resin board or fiberglass epoxy board whereby upon separation an image comprised of toner (B) was transferred to the surface of the board. The process of cooling, toning with toner (B), reheating and transferring the toned image to different copper clad boards was repeated 20 times.

Example 7

Example 3 was repeated through the image development step using a 50:50 mixture of the following toners:

| Component | Amount (g) |
|---|---|
| (A) Triphenyl phosphate | 360.0 |
| Polymethylmethacrylate/methacrylic acid described in Example 1 | 240.0 |
| Victoria® Pure Blue B.O. (C.I. No. Basic Blue 7) | 1.5 |
| (B) Triphenyl phosphate | 360.0 |
| Polymethylmethacrylate/methacrylic acid described in Example 1 | 240.0 |
| Carbon black | 218.0 |

Toned image transfers were effected as follows:

An aluminum plate suitable for the preparation of a lithographic printing plate having a silicate coated surface was preheated to 72°C. The photopolymer toned element was then heated to 85°C and brought into intimate contact with the preheated plate under high pressure in a nip formed by two rollers. A uniform looking image was transferred onto the aluminum plate. The transferred images were subsequently heat treated to 150°C for 5 minutes. A gum arabic scrubbing and cleanser solution was wiped on the transferred images., The transferred images were then used as lithographic printing plates to produce 12,500 inked impressions.

Example 8

Example 7 was repeated except that while the image transferred to the aluminum plate was still tacky, it was retoned with polystyrene beads of 1 to 15 micrometers particle size, the average being about 3.5 micrometers. The toned image was heat treated at 160°F (71°C) for about 5 minutes. Greater than 12,500 ink printing impressions were made, the toned image exhibiting good wear resistance.

Example 9

Example 1 was repeated except that the prolonged tack toner was transferred onto a copper clad phenolic resin board of the type used in the making of printed circuits. The circuit board containing the image was heated to 82.2°±5°C. While the toner was still tacky, it was retoned once with Xerox®

toner 6R208. It was then heated further, to the melting point of this second toner. After cooling, the board was etched and the toner image removed by washing with methylene chloride solvent to provide a printed circuit board having a copper design corresponding to the original image. Similar results were obtained using a copper clad fiberglass epoxy board in place of the copper clad phenolic resin board.

Example 10

Example 1 was repeated except that the prolonged tack toner was transferred onto a 0.007 inch (0.18 mm) polyethylene terephthalate film. The transferred image was retoned, heated to a temperature of 82°C whereby the toner was tackified. The toned image was cooled and retoned. The average optical density of the original image was 1.42, and the average optical density of the twice toned image was 2.74.

Example 11

The toned, transferred image on polyethylene terephthalate film prepared as described in Example 10 was mounted on cylinder 26 of the apparatus of Figure 2. It was then used as a master which was heated to about 82°C, toned with the prolonged tack toner, and the toner transferred to an aluminum plate of the type described in Example 7. After cooling, the image was retoned. This procedure was repeated a number of times producing multiple copies on separate aluminum plates.

Example 12

Example 1 was repeated except that the toned image was transferred onto an aluminum plate of the type described in Example 7. The imaged plate was then treated with a solution of 3.5 g of triethanolamine titanate chelate and 21.5 g of water. The plate was then heated for 35 seconds, its surface reaching a temperature of at least 150°C, and was mounted on an A.B. Dick offset duplicator Model 350. 58,000 Inked impressions were made without showing any wear signs as demonstrated by its ability to hold 5% dots.

While in the above examples a latent image of the type having tacky and nontacky areas was used to illustrate this invention, it is possible to practice this invention starting from an electrostatic or electromagnetic latent image.

Example 13

A latent image is generated on a magnetic film using a magnetic head. It is then toned through the application of a prolonged tack toner of the composition:

8.2 g polymethylmethacrylate acid
14.8 g triphenyl phosphate
23.0 g $Fe_3O_4$ powder sold by Pfizer Co. under the designation Product #MO7029

The developed magnetic image is then transferred onto a sheet of polyethylene terephthalate film by the application of pressure between two rollers forming a nip at a temperature of 45°C. The transferred image is then used as a master by mounting it on cylinder 26 of the apparatus of Figure 2 and proceeding as described in Example 11.

The original magnetic film can be cleaned of any residual toner and reused to produce a new magnetic image as desired, circumventing the need for a consumable film for magnetic dry printing process.

Example 14

An electrostatic image was developed on a substrate using a mixture of 150 grams of steel balls (C 1018 steel REP powder, −70 to +100 mesh, Nuclear Metals, Inc., Concord, Mass.), and 2 grams of a prolonged tack toner having the following composition:

| Component | Parts |
| --- | --- |
| Polymethylmethacrylate/methacrylic acid described in Example 1 | 19.8 |
| Triphenyl phosphate | 73.6 |
| Quinacridone pigment (Harmon colors RV 6803 with 15.9% polyvinyl pyrrolidone dispersant) | 6.6 |

The toned electrostatic image was placed in contact with a plain, white sheet of paper and by grounding the image, toner was transferred imagewise onto the sheet. The transferred toned image on the paper sheet was then heated to above the melting point of the toner and placed in contact with a sheet of polyethylene terephthalate film base, 0.004 inch (0.10 mm) thick coated with a resin sublayer, whereupon through the application of pressure, the toned image exhibited cohesive failure and partially transferred onto the polyethylene terephthalate base.

10

# 0 034 816

The transferred image on the base was then cooled and, while still tacky, retoned with a second prolonged tack toner having the following composition:

| Component | Parts |
| --- | --- |
| Polymethylmethacrylate/methacrylic acid described in Example 1 | 26.7 |
| Triphenyl phosphate | 66.7 |
| Quinacridone, polyvinyl pyrrolidone | 6.6 |

This retoned image on the polyethylene terephthalate base was again toned, heated, contacted with a lithographic aluminum sheet as described in Example 5, cooled, retoned, and the process repeated as disclosed in the previous examples, to produce at least four transfers of the original electrostatic image onto aluminum sheets.

## Claims

1. Process for image development of a substrate having latent image areas which comprises

(a) applying to the latent image areas a prolonged tack toner to produce a nontacky toned image,
(b) heating the toned image to a temperature sufficient to activate the toner by rendering the toner tacky, characterized by the further steps of
(c) reducing the temperature of the tackified toned image below the activating temperature of the prolonged tack toner wherein the activated prolonged tack toner remains tacky,
(d) further applying prolonged tack toner to the tackified toned image, and
(e) repeating steps (b) through (d) at least one time to increase the density of the toned image on the substrate.

2. A process according to Claim 1 wherein the latent image areas result from electrostatic imaging.

3. A process according to Claim 1 wherein the latent image areas result from electromagnetic imaging.

4. A process according to Claim 1 wherein the latent image areas are tacky and the background areas are nontacky.

5. A process according to Claim 4 wherein the substrate is a supported photosensitive layer which is photopolymerizable containing at least one free radical initiated, chain propagating, addition polymerizable compound containing at least one terminal ethylenic group, and an addition polymerization initiator activatable by actinic radiation.

6. A process for forming toned images from a substrate master having latent image areas which comprises

(a) applying to the latent image areas of the substrate a prolonged tack toner to produce a nontacky toned image,
(b) heating the toned image to a temperature sufficient to activate the toner by rendering the toner tacky,
(c) bringing the tacky toned substrate into intimate contact with an image receptor, and, while the toner is still activated,
(d) separating the substrate and image receptor whereby a portion of the activated prolonged tack toner transfers imagewise to the image receptor,

characterized in that following step (b) the step (b') reducing the temperature of the tackified toned substrate below the activating temperature of the prolonged tack toner wherein the toner remains tacky is performed and steps (a) and (b) are repeated at least one time.

7. A process according to claim 6, wherein steps (b), (c) and (d) are repeated at least one time using a separate image receptor in step (c).

8. A process for forming toned images from a substrate master having latent image areas which comprises

(a) applying to the latent image areas of the substrate a prolonged tack toner to produce a nontacky toned image,
(b) heating the toned image to a temperature sufficient to activate the toner by rendering the toner tacky,
(c) bringing the tacky toned substrate into intimate contact with an image receptor, and, while the toner is still activated,

11

(d) separating the substrate and image receptor whereby a portion of the activated prolonged tack toner transfers imagewise to the image receptor,

characterized in that following step (d), step (e) reducing the temperature of the prolonged tack toner transferred to the image receptor below the activating temperature of the prolonged tack toner and applying additional prolonged tack toner over the still tacky image to increase the density of the toned transferred image is performed.

9. A process according to Claim 8 wherein steps (b) through (d) are repeated at least one time using a separate image receptor in step (c).

10. A process according to any one of Claims 6, 7, 8 or 9 wherein said latent image areas result from electrostatic imaging.

11. A process according to any one of Claims 6, 7, 8 or 9 wherein said latent image areas result from electromagnetic imaging.

12. A process according to any one of Claims 6, 7, 8 or 9 wherein said latent image areas are tacky and the background areas are nontacky.

13. A process according to Claim 6 or 8 wherein the substrate master is a supported photosensitive layer which is photopolymerizable containing at least one free radical initiated, chain propagating, addition polymerizable compound containing at least one terminal ethylenic group, and an addition polymerization initiator activatable by actinic radiation.

14. A process according to Claim 6 or 8 wherein steps (a) to (d) are repeated up to four times using a substrate master having tacky and image areas and nontacky background areas on each of up to four substrates formed therein by exposure with actinic radiation through different color separation transparencies and the transfer step is accomplished by transferring in register toners of appropriate color with respect to the separation transparencies onto a single image receptor.

15. A process according to Claim 6 or 8 wherein the image receptor is paper.

16. A process according to Claim 6 or 8 wherein the image receptor is a copper clad laminate board which after image transfer is subsequently etched or plated to form a printed circuit.

17. A process according to Claim 6 or 8 wherein the image receptor is an aluminum plate and after image transfer the image is heated at a temperature up to 150°C, treated with lithographic solutions and inked to provide inked impressions on separate image receptors.

18. A process according to Claim 17 wherein after image transfer, while the image is still tacky and prior to heating, the toned image is retoned with polymer particles.

19. An apparatus for the production of multiple copies from a substrate master having tacky image areas and nontacky background areas onto an image receptor which comprises support means for the substrate capable of sequentially and cyclically transporting the substrate, in order, past the following stations located adjacent to the support means:

(1) a toner applicator to apply a uniform layer of prolonged tack toner particles onto the tacky image areas of the substrate (11);

(2) a toner cleaner extending the full width of the support means comprising an air knife (17) and at least one vacuum nozzle (16) located in close proximity to the air knife for removing toner particles dislodged from the nontacky background areas of the substrate by the action of the air knife; optionally

(3) a cleaning belt (18) held in contact with the support means and extending the full width of the support means capable of vibrating in a direction transverse to the direction in which the toned substrate is transported,

(4) heating means (23) for heating the toned substrate to raise the temperature of the prolonged tack toners above the temperature at which the toners become tackified,

(5) an image transfer means comprising rollers (26, 27) for bringing the tacky toned substrate into intimate contact with the image receptor (25), and characterized by

(6) a cooling air supply (31) extending the full width of the support means for providing cooling air over the toned substrate to reduce the temperature of the prolonged tack toners below the temperature at which the toners become tackified, the cooling air supply being located ahead of station (1).

20. An apparatus according to Claim 19 wherein the support means is a carrier belt (10).

21. An apparatus according to Claim 20 wherein the substrate master (11) is initially attached to the carrier belt at a point ahead of the toner applicator station (1).

22. An apparatus according to Claim 21 wherein the toner applicator station comprises a toner hopper (12).

23. An apparatus according to Claim 22 wherein the toner hopper has attached to a wall thereof a vibrating driving means (14) to impart vibratory motion to the hopper.

24. An apparatus according to Claim 23 wherein attached to the hopper and adjacent to the carrier belt is a brush (13) which redistributes toner over the tacky image bearing substrate master.

25. An apparatus according to Claim 24 wherein the cleaning belt station is present between the toner cleaner station and the heating station.

26. An apparatus according to Claim 25 wherein the heating station comprises infrared heaters.

27. An apparatus according to Claim 26 wherein operably adjacent to the image transfer means is guiding means (24, 30) to guide the image receptor (25) in and out of contact with the substrate master (11).

28. An apparatus according to Claim 27 wherein the cooling air supply station comprises a nozzle attached to a source of cold air.

29. An apparatus according to Claim 19 wherein the substrate master is a supported photosensitive layer which is photopolymerizable containing at least one free radical initiated, chain propagating, addition polymerizable compound containing at least one terminal ethylenic group, and an addition polymerization initiator activatable by actinic radiation.

**Revendications**

1. Procédé de développement d'image d'un substrat présentant des domaines d'image latente, selon lequel:

(a) on applique aux domaines d'image latente un révélateur à adhésivité prolongée pour obtenir une image révélée non adhésive,

(b) on chauffe l'image révélée à une température suffisante pour activer le révélateur en rendant celui-ci adhésif,

caractérisé en ce qu'en outre

(c) on réduit la température de l'image révélée rendue adhésive au-dessous de la température d'activation du révélateur à adhésivité prolongée de sorte que le révélateur à adhésivité prolongée activé demeure adhésif,

(d) on opère une nouvelle application de révélateur à adhésivité prolongée à l'image révélée et rendue adhésive, et

(e) on répète les opérations (b) à (d) au moins une fois afin d'accroître la densité de l'image révélée sur le substrat.

2. Procédé selon la revendication 1, dans lequel les domaines d'image latente sont obtenus par formation d'image électrostatique.

3. Procédé selon la revendication 1, dans lequel les domaines d'image latente sont obtenus par formation d'image électromagnétique.

4. Procédé selon la revendication 1, dans lequel les domaines d'image latente sont adhésifs tandis que les domaines de fond sont non adhésifs.

5. Procédé selon la revendication 4, dans lequel le substrat est une couche photosensible à support qui est photopolymérisable contenant au moins un composé polymérisable par addition par propagation de chaîne initiée par radicaux libres qui contient au moins un groupe éthylénique terminal, et un initiateur de polymérisation par addition activable par rayonnement actinique.

6. Procédé de formation d'images révélées à partir d'une image mère de substrat présentant des domaines d'image latente, selon lequel:

(a) on applique aux domaines d'image latente du substrat un révélateur à adhésivité prolongée afin d'obtenir une image révélée non adhésive,

(b) on chauffe l'image révélée à une température suffisante pour activer le révélateur en rendant celui-ci adhésif

(c) on amène le substrat révélé adhésif en contact intime avec un récepteur d'image et, pendant que le révélateur est encore activé,

(d) on sépare le substrat et le récepteur d'image de sorte qu'une partie du révélateur à adhésivité prolongée activé se transfère avec correspondance de points d'image au récepteur d'image,

caractérisé en ce qu'à la suite de l'opération (b) est effectuée l'opération (b') de réduction de la température du substrat révélé rendu adhésif au-dessous de la température d'activation du révélateur à adhésivité prolongée de sorte que le révélateur demeure adhésif, et en ce que les opérations (a) et (b) sont répétées au moins une fois.

7. Procédé selon la revendication 6, dans lequel les opérations (b), (c) et (d) sont répétées au moins une fois en utilisant un récepteur d'image distinct à l'opération (c).

8. Procédé de formation d'images révélées à partir d'une image mère de substrat présentant des domaines d'image latente, selon lequel:

(a) on applique aux domaines d'image latente du substrat un révélateur à adhésivité prolongée à l'effet d'obtenir une image révélée non adhésive,

(b) on chauffe l'image révélée à une température suffisante pour activer le révélateur en rendant celui-ci adhésif,

(c) on amène le substrat révélé adhésif en contact intime avec un récepteur d'image et, pendant que le révélateur est encore activé,

(d) on sépare le substrat et le récepteur d'image de sorte qu'une partie du révélateur à adhésivité prolongée activé se transfère avec correspondance de points d'image au récepteur d'image,

caractérisé en ce qu'à la suite de l'opération (d) est effectuée l'opération (e) de réduction de la température du révélateur à adhésivité prolongée transféré au récepteur d'image au-dessous de la température d'activation du révélateur à adhésivité prolongée et d'application d'un supplément de révélateur à adhésivité prolongée par-dessus l'image encore adhésive à l'effet d'accroître la densité de l'image transférée révélée.

9. Procédé selon la revendication 8, dans lequel les opérations (b) à (d) sont répétées au moins une fois en utilisant un récepteur d'image distinct à l'opération (c).

10. Procédé selon l'une quelconque des revendications 6, 7, 8 ou 9, dans lequel lesdits domaines d'image latente proviennent d'une formation d'image électrostatique.

11. Procédé selon l'une quelconque des revendications 6, 7, 8 ou 9, dans lequel lesdits domaines d'image latente proviennent d'une formation d'image électromagnétique.

12. Procédé selon l'une quelconque des revendications 6, 7, 8 ou 9, dans lequel lesdits domaines d'image latente sont adhésifs tandis que les domaines de fond sont non adhésifs.

13. Procédé selon la revendication 6 ou 8, dans lequel l'image mère de substrat est une couche photosensible à support qui est photopolymérisable et contient au moins un composé polymérisable par addition par propagation de chaîne initiée par radicaux libres contenant au moins un groupe éthylénique terminal, et un initiateur de polymérisation par addition activable par rayonnement actinique.

14. Procédé selon la revendication 6 ou 8, dans lequel les opérations (a) à (d) sont répétées jusqu'à quatre fois en utilisant une image mère de substrat présentant des domaines d'image adhésifs et des domaines de fond non adhésifs sur chacun d'entre plusieurs substrats en nombre allant jusqu'à quatre formés dans ceux-ci par exposition avec un rayonnement actinique à travers différentes diapositives de séparation de couleur, et dans lequel l'opération de transfert est effectuée par transfert en registre de révélateurs de couleurs appropriées en considération des diapositives de séparation sur un même récepteur d'image.

15. Procédé selon la revendication 6 ou 8, dans lequel le récepteur d'image est en papier.

16. Procédé selon la revendication 6 ou 8, dans lequel le récepteur d'image est une plaque de stratifié à revêtement de cuivre qui, après transfert d'image, est ensuite attaquée chimiquement ou plaquée à l'effet de former un circuit imprimé.

17. Procédé selon la revendication 6 ou 8, dans lequel le récepteur d'image est une plaque d'aluminium et, après transfert d'image, l'image est chauffée à une température pouvant aller jusqu'à 150°C, traitée avec des solutions lithographiques et encrée à l'effet de fournir des épreuves encrées sur des récepteurs d'image distincts.

18. Procédé selon la revendication 17, dans lequel, après transfert d'image, pendant que l'image est encore adhésive et préalablement au chauffage, l'image révélée est re-révélée avec des particules de polymère.

19. Appareil de production de copies multiples à partir d'une image mère de substrat présentant des domaines d'image adhésifs et des domaines de fond non adhésifs sur un récepteur d'image qui comprend un moyen de support pour le substrat propre à faire défiler successivement et cycliquement le support, dans l'ordre, devant les postes suivants, situés en adjacence au moyen de support:

(1) un applicateur de révélateur destiné à appliquer une couche uniforme de particules de révélateur à adhésivité prolongée sur les domaines d'image adhésifs du substrat (11);

(2) un éliminateur de révélateur s'étendant sur toute la largeur du moyen de support et comprenant un couteau à air (17) et au moins une buse d'aspiration (16) située au voisinage immédiat du couteau à air et destinée à éliminer les particules de révélateur détachées des domaines de fond non adhésifs du substrat sous l'action du couteau à air; facultativement,

(3) une bande de nettoyage (18) maintenue en contact avec le moyen de support et s'étendant sur toute la largeur du moyen de support, propre à vibrer dans une direction transversale par rapport à la direction dans laquelle défile le substrat révélé,

(4) un moyen de chauffage (23) destiné à chauffer le substrat révélé afin d'élever la température des révélateurs à adhésivité prolongée au-dessus de la température à laquelle les révélateurs deviennent adhésifs,

(5) un moyen de transfert d'image comprenant des rouleaux (26, 27) destinés à amener le substrat révélé adhésif en contact intime avec le récepteur d'image (25),

et caractérisé par

(6) une alimentation d'air de refroidissement (31) s'étendant sur toute la largeur du moyen de support à l'effet de fournir un apport d'air de refroidissement par-dessus le substrat révélé afin de réduire la température des révélateurs à adhésivité prolongée au-dessous de la température à laquelle les révélateurs deviennent adhésifs, l'alimentation d'air de refroidissement étant située en avant du poste (1).

20. Appareil selon la revendication 19, dans lequel le moyen de support est une bande porteuse (10).

21. Appareil selon la revendication 20, dans lequel l'image mère de substrat (11) est initialement fixée à la bande porteuse en un point situé en avant du poste applicateur de révélateur (1).

22. Appareil selon la revendication 21, dans lequel le poste applicateur de révélateur comprend une trémie à révélateur (12).

23. Appareil selon la revendication 22, dans lequel la trémie à révélateur comporte un moyen d'excitation vibrant (14) fixé à une paroi de celle-ci et destinée à imprimer un mouvement vibratoire à la trémie.

24. Appareil selon la revendication 23, dans lequel est fixée à la trémie à proximité de la bande porteuse une brosse (13) qui redistribue le révélateur par-dessus l'image mère de substrat porteuse d'image adhésive.

25. Appareil selon la revendication 24, dans lequel le poste à bande de nettoyage est situé entre le poste éliminateur de révélateur et le poste de chauffage.

26. Appareil selon la revendication 25, dans lequel le poste de chauffage comprend des organes de chauffage par infrarouge.

27. Appareil selon la revendication 26, dans lequel en adjacence fonctionnelle au moyen de transfert d'image est disposé un moyen de guidage (24, 30) destiné à guider le récepteur d'image (25) à sa venue en contact et à sa séparation d'avec l'image mère de substrat (11).

28. Appareil selon la revendication 27, dans lequel le poste d'alimentation d'air de refroidissement comprend une buse reliée à une source d'air froid.

29. Appareil selon la revendication 19, dans lequel l'image mère de substrat est une couche photosensible à support qui est photopolymérisable et contient au moins un composé photopolymérisable par addition par propagation de chaîne à initiation par radicaux libres contenant au moins un groupe éthylénique terminal, et un initiateur de polymérisation par addition activable par rayonnement actinique.

**Patentansprüche**

1. Verfahren zur Bildentwicklung eines Substrats mit latenten Bildbereichen mit den Schritten

(a) Aufbringen eines Toners mit verlängerter Klebefähigkeit auf die latenten Bildbereiche zur Erzeugung eines nicht-klebrigen getonten Bildes,

(b) Erhitzen des getonten Bildes auf eine zur Aktivierung des Toners durch Klebrigmachen des Toners ausreichende Temperatur,

gekennzeichnet durch die weiteren Schritte:

(c) Reduzieren der Temperatur des klebrig gemachten getonten Bildes auf eine Temperatur unterhalb der Aktivierungstemperatur des Toners mit verlängerter Klebefähigkeit, wobei der Toner mit verlängerter Klebefähigkeit klebrig bleibt,

(d) weiteres Aufbringen von Toner mit verlängerter Klebefähigkeit auf das klebrig gemachte getonte Bild und

(e) Wiederholen der Schritte (b) bis (d) wenigstens einmal zur Steigerung der Dichte des getonten Bildes auf dem Substrat.

2. Verfahren nach Anspruch 1, dadurch gekennzeichnet, daß die latenten Bildbereiche aus elektrostatischer Abbildung resultieren.

3. Verfahren nach Anspruch 1, dadurch gekennzeichnet, daß die latenten Bildbereiche aus elektromagnetischer Abbildung resultieren.

4. Verfahren nach Anspruch 1, dadurch gekennzeichnet, daß die latenten Bildbereiche klebrig sind und die Hintergrundbereiche nicht-klebrig sind.

5. Verfahren nach Anspruch 4, dadurch gekennzeichnet, daß das Substrat eine trägerunterstützte lichtempfindliche Schicht ist, die photopolymerisierbar ist und wenigstens eine Verbindung, die in einer durch freie Radikale ausgelösten Kettenfortpflanzung additionspolymerisierbar ist und wenigstens eine endständige ethylenische Gruppe enthält, und einen Additionspolymerisations-Initiator, der durch aktinische Strahlung aktivierbar ist, enthält.

**0 034 816**

6. Verfahren zur Bildung getonter Bilder aus einem Substrat-Modell (Master) mit den Schritten

(a) Aufbringen eines Toners mit verlängerter Klebefähigkeit auf die latenten Bildbereiche des Substrats zur Erzeugung eines nicht-klebrigen getonten Bildes,

(b) Erhitzen des getonten Bildes auf eine zur Aktivierung des Toners durch Klebrigmachen des Toners ausreichende Temperatur,

(c) Bringen des klebrigen getonten Substrats in innige Berührung mit einem Bildrezeptor und, während der Toner noch aktiviert ist,

(d) Trennen des Substrats und des Bildrezeptors, wodurch ein Teil des aktivierten Toners mit verlängerter Klebefähigkeit bildweise auf den Bildrezeptor übergeht,

dadurch gekennzeichnet, daß nach dem Schritt (b) der Schritt

(b') Reduzieren der Temperatur des klebrig gemachten getonten Substrats auf eine Temperatur unterhalb der Aktivierungstemperatur des Toners mit verlängerter Klebefähigkeit, wobei der Toner mit verlängerter Klebefähigkeit klebrig bleibt,

durchgeführt wird und die Schritte (a) und (b) wenigstens einmal wiederholt werden.

7. Verfahren nach Anspruch 6, dadurch gekennzeichnet, daß die Schritte (b), (c) und (d) wenigstens einmal widerholt werden, wobei in Schritt (c) ein separater Bildrezeptor eingesetzt wird.

8. Verfahren zur Bildung getonter Bilder aus einem Substrat-Master mit den Schritten

(a) Aufbringen eines Toners mit verlangerter Klebefähigkeit auf die latenten Bildbereiche des Substrats zur Erzeugung eines nicht-klebrigen getonten Bildes,

(b) Erhitzen des getonten Bildes auf eine zur Aktivierung des Toners durch Klebrigmachen des Toners ausreichende Temperatur,

(c) Bringen des klebrigen getonten Substrats in innige Berührung mit einem Bildrezeptor und, während der Toner noch aktiviert ist,

(d) Trennen des Substrats und des Bildrezeptors, wodurch ein Teil des aktivierten Toners mit verlängerter Klebefähigkeit bildweise auf den Bildrezeptor übergeht,

dadurch gekennzeichnet, daß nach dem Schritt (d) der Schritt

(e) Reduzieren der Temperatur des auf den Bildrezeptor übergegangenen Toners mit verlängerter Klebefähigkeit auf eine Temperatur unterhalb der Aktivierungstemperatur des Toners mit verlängerter Klebefähigkeit und Aufbringen von zusätzlichem Toner mit verlängerter Klebefähigkeit auf das noch klebrige Bild zur Steigerung der Dichte des getonten übertragenen Bildes

durchgeführt wird.

9. Verfahren nach Anspruch 8, dadurch gekennzeichnet, daß die Schritte (b) bis (d) wenigstens einmal wiederholt werden, wobei in Schritt (c) ein separater Bildrezeptor eingesetzt wird.

10. Verfahren nach irgendeinem der Ansprüche 6, 7, 8 oder 9, dadurch gekennzeichnet, daß die latenten Bildbereiche aus elektrostatischer Abbildung resultieren.

11. Verfahren nach irgendeinem der Ansprüche 6, 7, 8 oder 9, dadurch gekennzeichnet, daß die latenten Bildbereiche aus elektromagnetischer Abbildung resultieren.

12. Verfahren nach irgendeinem der Ansprüche 6, 7, 8 oder 9, dadurch gekennzeichnet, daß die latenten Bildbereiche klebrig sind und die Hintergrundbereiche nichtklebrig sind.

13. Verfahren nach Anspruch 6 oder 8, dadurch gekennzeichnet, daß der Substrat-Master eine trägerunterstützte lichtempfindliche Schicht ist, die photopolymerisierbar ist und wenigstens eine Verbindung, die in einer durch freie Radikale ausgelösten Kettenfortpflanzung additionspolymerisierbar ist und wenigstens eine endständige ethylenische Gruppe enthält, und einen Additionspolymerisations-Initiator, der durch aktinische Strahlung aktivierbar ist, enthält.

14. Verfahren nach Anspruch 6 oder 8, dadurch gekennzeichnet, daß die Schritte (a) bis (d) bis zu viermal wiederholt werden, wobei ein Substrat-Master mit klebrigen Bildbereichen und nicht-klebrigen Hintergrundbereichen auf jedem der bis zu vier Substrate verwendet wird, die darin durch Belichtung mit aktinischer Strahlung durch verschiedene transparente Farbauszug-Vorlagen hindurch gebildet werden, und der Übertragungs-Schritt so durchgeführt, daß der Reihe nach Toner der zu den Farbauszug-Vorlagen passenden Farben jeweils auf eine einzelnen Bildrezeptor übertragen werden.

15. Verfahren nach Anspruch 6 oder 8, dadurch gekennzeichnet, daß der Bildrezeptor Papier ist.

16. Verfahren nach Anspruch 6 oder 8, dadurch gekennzeichnet, daß der Bildrezeptor eine mit Kupfer überzogene Verbundplatte ist, die nach der Bildübertragung zur Bildung einer gedruckten Schaltung anschließend geätzt oder plattiert wird.

17. Verfahren nach Anspruch 6 oder 8, dadurch gekennzeichnet, daß der Bildrezeptor eine Aluminium-Platte ist und nach der Bildübertragung das Bild auf eine Temperatur bis zu 150°C erhitzt wird, mit lithographischen Lösungen behandelt wird und eingefärbt wird, um mit Druckfarbe eingefärbte Abdrucke auf getrennten Bildrezeptoren zu schaffen.

16

# 0 034 816

18. Verfahren nach Anspruch 17, dadurch gekennzeichnet, daß nach der Bildübertragung, während das Bild noch klebrig ist, und vor dem Heizen das getonte Bild mit Polymer-Teilchen nachgetont wird.

19. Gerät zur Herstellung von Mehrfach-Kopien von einem Substrat-Master mit klebrigen Bildbereichen und nichtklebrigen Hintergrundbereichen auf Bildrezeptoren mit einer Träger-Vorrichtung für das Substrat, die befähigt ist, das Substrat nacheinander und im Cyclus, der Reihe nach, durch die folgenden Stationen zu befördern, die der Träger-Vorrichtung benachbart angeordnet sind:

(1) einen Toner-Applikator zum Aufbringen einer gleichmäßigen Schicht eines Toners mit verlängerter Klebefähigkeit auf die klebrigen Bildbereiche des Substrats (11);

(2) einen sich über die volle Breite der Träger-Vorrichtung erstreckender Toner-Reiniger mit einer Luftbürste (17) und wenigstens einer in enger Nachbarschaft zu der Luftbürste angeordneten Vakuumdüse (16) zur Entfernung von Toner-Teilchen, die von den nicht-klebrigen Hintergrundbereichen des Substrats durch die Einwirkung der Luftbürste vertrieben wurden; wahlweise

(3) ein in Berührung mit der Träger-Vorrichtung gehaltenes und sich über die volle Breite der Träger-Vorrichtung erstreckendes Reinigungsband (18), das befähigt ist, in einer Richtung senkrecht zur Transportrichtung des getonten Substrats zu schwingen,

(4) eine Heizvorrichtung (23) zum Beheizen des getonten Substrats zur Erhöhung der Temperatur der Toner mit verlängerter Klebefähigkeit auf eine Temperatur oberhalb derjenigen, bei der die Toner klebrig gemacht werden,

(5) eine Bildübertragungs-Vorrichtung (5) mit Walzen (26, 27), mittels deren das klebrige getonte Substrat in innige Berührung mit dem Bildrezeptor (25) gebracht wird,

und gekennzeichnet durch

(6) eine sich über die volle Breite der Träger-Vorrichtung erstreckende Kühlluft-Zufuhr (31) zur Zuführung von Kühlluft über das getonte Substrat zur Erniedrigung der Temperatur der Toner mit verlängerter Klebefähigkeit auf eine Temperatur unterhalb derjenigen, bei der die Toner klebrig gemacht werden, wobei die Kühlluft-Zufuhr vor der Station (1) angeordnet ist.

20. Gerät nach Anspruch 19, dadurch gekennzeichnet, daß die Träger-Vorrichtung ein Transportband ist.

21. Gerät nach Anspruch 20, dadurch gekennzeichnet, daß der Substrat-Master (11) anfänglich an dem Transportband an einem Punkt vor der Toner-Applikator-Station (1) befestigt wird.

22. Gerät nach Anspruch 21, dadurch gekennzeichnet, daß die Toner-Applikator-Station einen Toner-Einfülltrichter (12) umfaßt.

23. Gerät nach Anspruch 22, dadurch gekennzeichnet, daß der Toner-Einfülltrichter, befestigt an einer seiner Wände, eine Vibrations-Antriebsvorrichtung (14) aufweist, die den Einfülltrichter in eine Schwingungsbewegung versetzt.

24. Gerät nach Anspruch 23, dadurch gekennzeichnet, daß befestigt an dem Einfülltrichter und in der Nähe des Transportbandes sich eine Bürste (13) befindet, die den Toner über den klebrigen, bildtragenden Substrat-Master wieder verteilt.

25. Gerät nach Anspruch 24, dadurch gekennzeichnet, daß die Reinigungsband-Station zwischen der Toner-Reiniger-Station und der Heizstation angeordnet ist.

26. Gerät nach Anspruch 25, dadurch gekennzeichnet, daß die Heizstation Infrarot-Heizungen enthält.

27. Gerät nach Anspruch 26, dadurch gekennzeichnet, daß in Nachbarschaft zu der Bildübertragungs-Vorrichtung Führungsmittel (24, 30) betreibbar sind, um den Bildrezeptor (25) in die Berührung mit dem Substrat-Master (11) hinein und aus dieser heraus zu führen.

28. Gerät nach Anspruch 27, dadurch gekennzeichnet, daß die Kühlluft-Zufuhr eine mit einer Kaltluft-Quelle verbundenen Düse enthält.

29. Gerät nach Anspruch 19, dadurch gekennzeichnet, daß der Substrat-Master eine trägerunterstützte lichtempfindliche Schicht ist, die photopolymerisierbar ist und wenigstens eine Verbindung, die in einer durch freie Radikale ausgelösten Kettenfortpflanzung additionspolymerisierbar ist und wenigstens eine endständige ethylenische Gruppe enthält, und einen Additionspolymerisations-Initiator, der durch aktinische Strahlung aktivierbar ist, enthält.

17

# *FIG. I*

```
┌─────────────────────┐
│   LATENT  IMAGE     │
└─────────────────────┘
           │
┌─────────────────────┐
│  APPLICATION OF     │
│  DELAYED TACK       │
│     TONER           │
└─────────────────────┘
           │
┌─────────────────────┐
│  ACTIVATION OF      │
│  DELAYED TACK       │
│     TONER           │
└─────────────────────┘
           │
┌─────────────────────┐
│  PARTIAL TRANSFER   │
│  OF TONED IMAGE     │
│  TO FORM COPY       │
└─────────────────────┘
```

# FIG. 2